# EUROPEAN PATENT SPECIFICATION

(11) **EP 1 612 836 B1**
(45) Date of publication and mention of the grant of the patent: **24.02.2010**
(21) Application number: 05076464.6
(22) Date of filing: 27.06.2005
(51) Int. Cl.: H01J 37/305

(54) **Method for the removal of a microscopic sample from a substrate**
Methode zum Entfernen einer mikroskopischen Probe von einem Substrat
Méthode pour enlever un spécimen microscopique d'un substrat

(30) Priority: 01.07.2004 EP 04076892
(43) Date of publication of application: 04.01.2006
(73) Proprietor: FEI COMPANY, Hillsboro, Oregon 97124-5793 (US)
(72) Inventor: Tappel, Henk Gezinus, 5529 AC Casteren (NL)
(74) Representative: Bakker, Hendrik

(56) References cited:
- US-A- 5 009 743
- US-A1- 2002 050 565
- US-B1- 6 538 254

## Description

The invention pertains to a method for the removal of a microscopic sample from a substrate, comprising the steps of:
- performing a cutting process whereby the substrate is irradiated with a beam such that the sample is cut out of the substrate, and
- performing an adhesion process whereby the sample is adhered to a probe.

Such a method is known from US patent document No. 5,270,552.

A method such as this is employed in particular in the semiconductor industry, where samples of microscopic proportions are taken out of substrates such as wafers in order to facilitate analysis and/or further processing. These days, such samples have dimensions of the order of magnitude of 10µm at a thickness of 100nm. A trend exists towards an even further size-reduction in the structures of interest, and, as a result hereof, a further size-reduction in the samples to be extracted.

The analyses which are made of such microscopic samples can be carried out, for example, with the aid of a TEM (Transmission Electron Microscope), SEM (Scanning Electron Microscope), SIMS (Secondary Ion Mass Spectroscope) or with X-Ray analysis equipment. The further processing/manipulations can consist of, for example, making the sample thinner with the aid of an ion beam for the purposes of analysis with the aid of a TEM.

With the method described in the aforementioned patent document, a needle-shaped probe is moved by a manipulator to a position on a substrate where a sample is to be extracted. The sample is cut away from the substrate by removing material from two different directions with a focused ion-beam.

Prior to completely cutting the sample out of the substrate, the sample is adhered to the extremity of the probe by means of, for example, metal deposition. After the sample is completely cut away the sample adhered to the probe is moved to another position with the aid of the manipulator.

It is to be noted that, prior to commencing the adhesion process, part of the cutting process must first be performed. After all, the presence of the needle-shaped probe causes shadow-formation; the presence of the probe will render a portion of the substrate invisible to the ion-beam deployed. For that reason, it is necessary to first commence the cutting process and then only move the probe to the sample position upon completion of the cutting in that region of the substrate that will come to lie in the shadow of the sample holder. Only thereafter can the adhesion process be started, whereupon the cutting process can be recommenced in order to completely extract the sample.

The US patent document US6538254 B discloses a method for fabrication of a micro-specimen comprising fixing the specimen to a probe and extracting and separating the micro-specimen from the specimen substrate. A first ion beam, e.g. a projection ion beam, is used for trench formation on the surface of the specimen substrate and a second ion beam, e.g. a focused ion beam, is used for bottom dividing of the micro-sample. A similar method, where both ion beams are focused ion beams is disclosed in US2002/0050565 A.

It is an aim of the invention to provide a method of the type mentioned in the opening paragraph which provides for time-saving compared to the known methods.

To that end, the method according to the invention is characterized in that the cutting process, during at least part of the duration of the cutting process, is carried out by two beams simultaneously.

In the known methods, the sample is cut from the substrate by irradiating the substrate sequentially from two different directions. In some of the prior art also two different beams are used for this. By carrying out the method with the aid of a device wherein multiple cutting beams are active at the same time, the irradiation can occur from different directions simultaneously with two or more beams. This leads to the intended time-saving.

In an embodiment of the method according to the invention the orientation of the substrate with respect to the radiation sources remains unchanged during the cutting process.

In order to cut the sample away from the substrate, a wedge-shaped cut will generally have to be made. In the known method a first cut is first made, whereupon the angle of incidence of the cutting beam with respect to the substrate is changed and a second cut is made. Altering the angle of incidence of the cutting beam usually occurs through changing the orientation of the substrate.

It is to be noted that a change in the orientation of the substrate with respect to the beam will usually imply an attendant change in the position of the substrate. Because of this, changing the orientation will require a repositioning of the substrate with respect to the means which produce the beams.

If, however, more than one beam is available, these beams will generally subtend an angle with respect to one another. Because of this, the sample can be completely extracted without having to change the orientation of the substrate.

The elimination of the need to reposition saves a non-negligible amount of time. After all, the repositioning of substrate and beam must occur with a high degree of accuracy. These days, a sample to be extracted will have dimensions of the order of magnitude of 10µm at a thickness of 100nm. Repositioning will therefore generally comprise not only moving the substrate, but also determining with sub-micron accuracy the position of the sample with respect to the means which produce both of the beams.

It is to be noted that in, in general, the beam is positioned with respect to the substrate with the aid of deflecting means. The orientation of the beam varies hereby slightly with respect to the substrate. However, this change of angle cannot generally be used to cut out the sample all around. After all, in order to cut away a wedge-shaped sample, it is a requirement that the beams intersect each other in the sample, a feat which is not easily achieved when the beams are deflected by deflection means that are placed outside the substrate.

In another embodiment of the method according to the invention, the adhesion process comprises irradiating with a beam.

Adhering the sample to the probe with the aid of a beam can take place using a method known *per se,* whereby a metal deposition is applied, with the aid of, for example, an ion beam. This adhesion can be carried out using one of the beams with which, for at least part of the time, the cutting process is performed, but the beam can also be a different beam than the beams which perform the cutting.

It is to be noted that it is possible to change the function of an ion-beam from erosion (the removal of material) to deposition (the application of material) by changing certain properties of the beam, such as the current-density.

It is also to be noted that the beam with which the adhesion process is performed does not necessarily have to be of the same type as the type with which the cutting process is performed. It is conceivable that a beam of ions be used for cutting and a beam of photons or an electron beam be used for the adhesion process.

In a further method according to the invention, the adhesion process and the cutting process overlap each other temporally.

Before rounding off the cutting process it is desired that the sample be affixed to the probe. By allowing the cutting process and the adhesion process to overlap each other in time, a further time-saving is realized. One can envisage hereby that cutting is at first performed with two beams, after which one of the beams performs cutting while the other beam simultaneously performs adhesion.

In a preferential embodiment of the method according to the invention, the aforementioned irradiation comprises irradiating with beams of electrically charged particles.

The use of a beam of electrically-charged particles, in particular a beam of ions, for the cutting process is a method known *per se*. Also, for the adhesion process, the application of a metal deposit with the aid of an ion beam is a method known *per se*.

It is also to be noted that the irradiation with electrically charged particles can occur coincident with, for example, the presence of special gases, whereby, for example, the cutting-speed of the beam(s) can be increased or the application of a metal deposition becomes possible.

The invention will be further elucidated on the basis of figures, whereby corresponding elements are depicted using the same reference numbers. To this end:
- Figure 1 shows a schematic depiction of a particle-optical device for carrying out the invention, equipped with two columns, each of which produces an ion beam,
- Figure 2A shows a schematic representation of a substrate from which a sample is cut away by two beams,
- Figure 2B shows a schematic representation of a transverse cross-section from figure 2A, and
- Figure 3 shows a schematic representation of a substrate with a partially cut-away sample that is being affixed to a needle-shaped extremity of a probe.

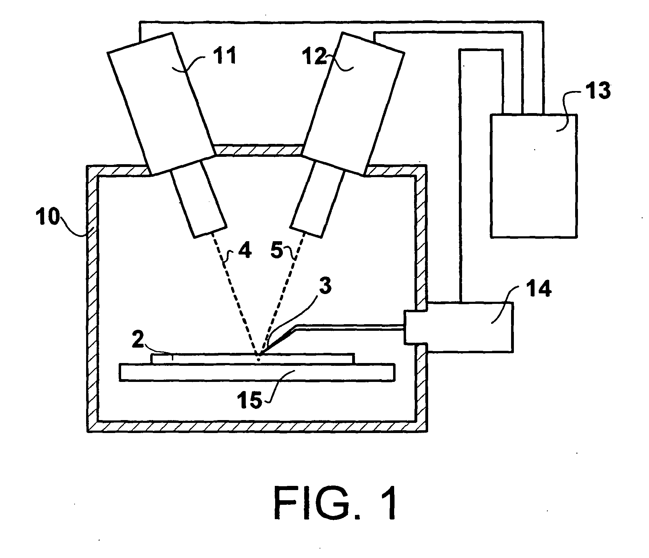

Figure 1 schematically depicts a particle-optical device suited to the performance of the method according to the invention, equipped with two columns 11 and 12, each of which produces an ion beam 4 and 5, respectively.

The particle-optical device comprises a vacuum chamber 10, a first column 11 - mounted on the vacuum chamber 10 - for the production of a first ion beam 4, a second column 12 - mounted on the vacuum chamber 10 - for the production of a second ion beam 5, control means 13 embodied to simultaneously operate columns 11 and 12, a probe 14 which can be manipulated, and a substrate carrier 15 which can be positioned.

The vacuum chamber 10 is maintained, by means of (non-depicted) evacuation means, in vacuum or at least at a pressure significantly less than atmospheric pressure. The columns 11 and 12 are mounted to the vacuum chamber 10 at such an orientation that the ion beams 4 and 5 produced by these columns practically intersect each other.

A substrate in the form of a wafer 2 placed on the positionable substrate carrier 15 is positioned with the aid of the positionable substrate carrier 15 in such a manner that a sample 1 which is to be extracted lies practically at the intersection of the two beams 4 and 5. The cutting process can commence hereafter.

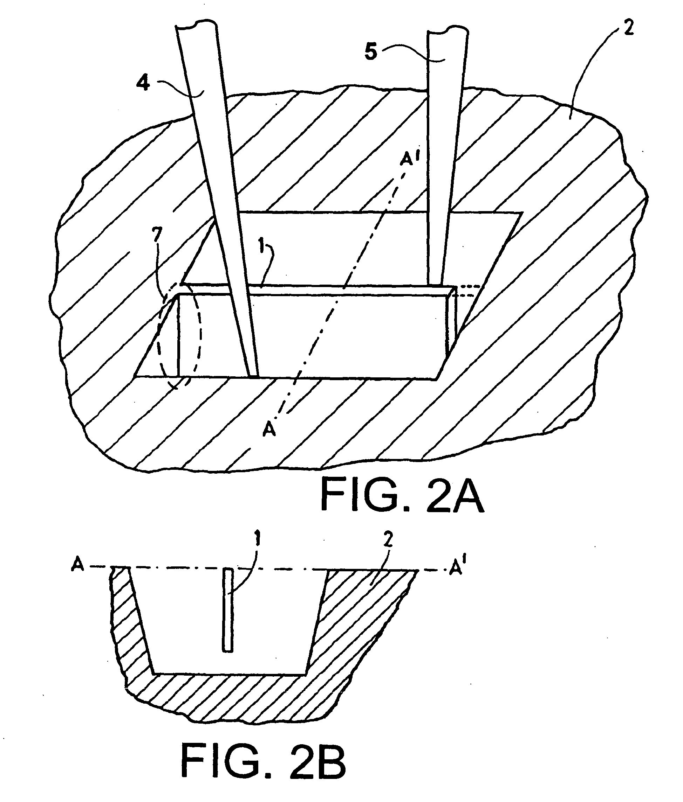

Figures 2A and 2B schematically depict a substrate in the form of a wafer 2 from which a sample 1 is cut away by two beams 4 and 5.

Figure 2A shows how sample 1 is cut away from wafer 2 by two ion beams 4 and 5 simultaneously. Because the two beams 4 and 5 subtend an angle with respect to each other, it is possible to cut out the sample 1 all around without the wafer 2 having to assume another orientation with respect to the columns 11 and 12 that produce the beams 4 and 5.

In the situation shown, the bottom side of sample 1 is already largely cut away, whereupon the sample 1 will only remain connected to the wafer 2 by the connection 7 between the wafer 2 and the sample 1.

These days, a sample to be extracted will typically have dimensions of the order of magnitude of 10µm (that is to say length perpendicular to line AA') and a thickness (that is to say dimension in the direction of line AA') of 100nm.

Figure 2B shows a transverse cross-section according to line AA' depicted in figure 2A, whereby it can be clearly seen that the sample 1 is free at the lower surface from the wafer 2.

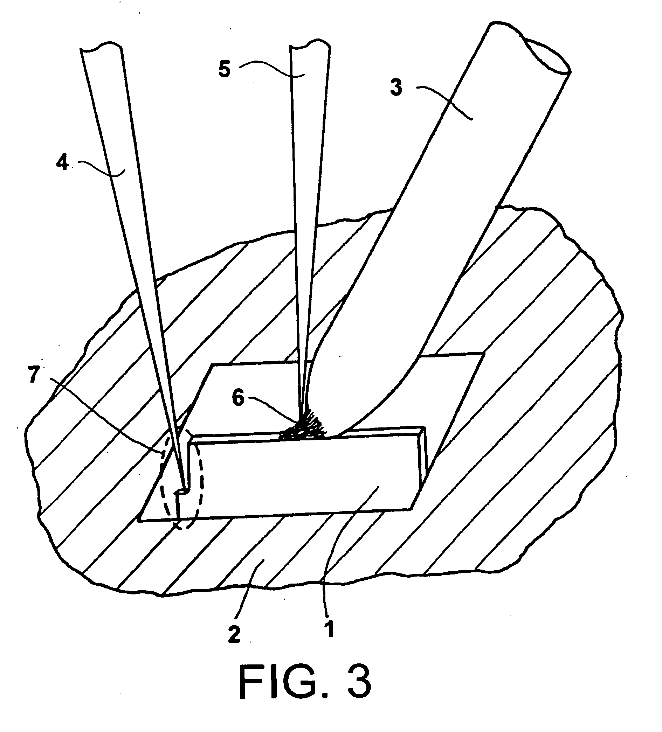

Figure 3 schematically depicts a sample 1 that is being affixed at the extremity of the probe 3.

The cutting process in the depicted situation is sufficiently progressed that no further shadow-effect of the probe 14 is to be feared. The needle-shaped extremity 3 of the probe 14, which can be manipulated, is moved to the position of the sample 1 to be extracted. The sample 1 is connected to the extremity 3 of probe 14 by irradiation with an ion beam 5, whereby a metal deposit 6 adheres the sample 1 to the probe 14. At the same time, the remaining connection 7 between the sample 1 and the wafer 2 is removed with ion beam 4. After the cutting is completely finished, the sample 1 that is adhered to the probe 14 can be taken away.

## Claims

1. A method for the removal of a microscopic sample (1) from a substrate (2), comprising:
• performing a cutting process whereby the substrate (2) is irradiated with at least two beams (4) such that the sample (1) is cut out of the substrate (2), and
• performing an adhesion process whereby the sample (1) is adhered to a probe (3),
**characterized in that**
• the cutting process, during at least part of the duration of the cutting process, is carried out by said at least two beams (4, 5) simultaneously.

2. A method according to claim 1 whereby, during the cutting process, the orientation of the substrate (2) in relation to the means which produce the two beams (4, 5) remains unchanged.

3. A method according to one of the preceding claims, whereby the adhesion process comprises the irradiation of the sample (1) with a beam (5).

4. A method according to claim 3, whereby the adhesion process and the cutting process overlap each other temporally.

5. A method according to one of the preceding claims, whereby the irradiation comprises irradiating with beams (4, 5) of electrically charged particles

## Patentansprüche

1. Verfahren zum Entnehmen einer mikroskopischen Probe (1) von einem Substrat (2), mit den Schritten:
Ausführen eines Schneidprozesses, in dem das Substrat (2) durch mindestens zwei Strahlen (4) bestrahlt wird, so dass die Probe (1) aus dem Substrat (2) ausgeschnitten wird; und
Ausführen eines Adhäsionsprozesses, in dem die Probe (1) an eine Sonde (3) angehaftet wird;
**dadurch gekennzeichnet, dass**
der Schneidprozess mindestens während eines Teils der Dauer des Schneidprozesses durch die mindestens zwei Strahlen (4, 5) gleichzeitig ausgeführt wird.

2. Verfahren nach Anspruch 1, wobei die Ausrichtung des Substrats (2) bezüglich der Einrichtung, die die beiden Strahlen (4, 5) erzeugt, während des Schneidprozesses unverändert bleibt.

3. Verfahren nach einem der vorangehenden Ansprüche, wobei der Adhäsionsprozess das Bestrahlen der Probe (1) mit einem Strahl (5) aufweist.

4. Verfahren nach Anspruch 3, wobei der Adhäsionsprozess und der Schneidprozess sich zeitlich einander überlappen.

5. Verfahren nach einem der vorangehenden Ansprüche, wobei das Bestrahlen das Bestrahlen mit Strahlen (4, 5) elektrisch geladener Teilchen aufweist.

## Revendications

1. Procédé pour le retrait d'un échantillon microscopique (1) d'un substrat (2) comprenant :
. la mise en oeuvre d'un processus de découpage où le substrat (2) est irradié avec au moins deux faisceaux (4) de telle sorte que l'échantillon (1) est retiré du substrat (2) par découpage, et
. la mise en oeuvre d'un processus d'adhésion où l'échantillon (1) est amené à adhérer à une sonde (3),
**caractérisé en ce que**
. le processus de découpage, pendant au moins une partie de la durée du processus de découpage, est mis en oeuvre par lesdits au moins deux faisceaux (4, 5) simultanément.

2. Procédé selon la revendication 1 où, pendant le processus de découpage, l'orientation du substrat (2) par rapport aux moyens qui produisent les deux faisceaux (4, 5) reste inchangée.

3. Procédé selon l'une des revendications précédentes où le processus d'adhésion comprend l'irradiation de l'échantillon (1) avec un faisceau (5).

4. Procédé selon la revendication 3 où le processus d'adhésion et le processus de découpage se chevauchent dans le temps.

5. Procédé selon l'une des revendications précédentes où l'irradiation comprend une radiation avec des faisceaux (4, 5) de particules électriquement chargées.
